# EUROPEAN PATENT APPLICATION

(11) **EP 4 366 478 A1**
(43) Date of publication of application: **08.05.2024**
(21) Application number: 23207662.0
(22) Date of filing: 03.11.2023
(51) Int. Cl.: H05K 5/00, H05K 7/20

(54) **CONTROLLER AND VEHICLE COMPRISIN THE CONTROLLER**

(30) Priority: 04.11.2022 CN 202211380737
(71) Applicant: Nio Technology (Anhui) Co., Ltd, Hefei City, Anhui 230601 (CN)
(72) Inventor: LIU, Shuaijie, Hefei City, 230601 (CN); SHI, Jiepei, Hefei City, 230601 (CN); GAO, Xianglong, Hefei City, 230601 (CN)
(74) Representative: v. Bezold & Partner Patentanwälte - PartG mbB

(57) **Abstract**

A controller of the disclosure comprises an intelligent cockpit daughter board, an intelligent driving daughter board, a mother board and an intermediate plate, the intelligent cockpit daughter board and the intelligent driving daughter board being provided with an intelligent cockpit chip and an intelligent driving chip respectively, the intelligent cockpit daughter board and the intelligent driving daughter board being arranged on one side of the intermediate plate, and the mother board being arranged on the other side of the intermediate plate. According to the controller of the disclosure, an intelligent cockpit core chip and an intelligent driving core chip are respectively arranged on two daughter boards, and the two daughter boards share one mother board, which is more convenient for maintenance and upgrading.

## Description

### TECHNICAL FIELD

The disclosure relates to the technical field of controllers, and in particular to a controller and a vehicle comprising the controller.

### BACKGROUND

In a conventional domain controller, an intelligent driving hardware and an intelligent cockpit hardware are separate components. The intelligent driving hardware is configured to provide an electric vehicle with an autonomous driving system, such as a vehicle operation system that fully automates the work performed by a driver and is highly centralized, such that the vehicle has the functions of automatic wake-up startup and hibernation, entering and leaving a parking lot automatically, automatic cleaning, automatic driving, automatic parking, automatic door opening and closing, automatic fault recovery, etc., and multiple operation modes can be selected according to information such as road conditions. The intelligent cockpit hardware is configured to provide human-vehicle interaction for an electric vehicle, such as providing emotion recognition, age determination, left things detection, seat belt detection, etc. by means of cameras mounted on AB pillars and a rear mirror of the vehicle, can automatically adjust the temperature, humidity and lighting of the cockpit, and can also provide audiovisual entertainment similar to that on mobile phones. However, the intelligent driving hardware and the intelligent cockpit hardware are arranged separately, which not only results in high overall hardware cost, but also hinders deep electronic and electrical integration, making maintenance and upgrading inconvenient.

Accordingly, a new controller is required in the field to address the problems of high cost and inconvenient maintenance and upgrading of the existing intelligent driving hardware and intelligent cockpit hardware.

### SUMMARY

The disclosure aims to solve the foregoing technical problems, that is, to solve the problems of high cost and inconvenient maintenance and upgrading of the existing intelligent driving hardware and intelligent cockpit hardware.

According to a first aspect, the disclosure provides a controller, the controller comprising an intelligent cockpit daughter board, an intelligent driving daughter board, a mother board and an intermediate plate, the intelligent cockpit daughter board being provided with an intelligent cockpit chip, the intelligent driving daughter board being provided with an intelligent driving chip, the intelligent cockpit daughter board and the intelligent driving daughter board being arranged on one side of the intermediate plate, and the mother board being arranged on the other side of the intermediate plate.

In a preferred technical solution of the controller, the controller further comprises a heat dissipation cover plate, the heat dissipation cover plate being arranged on the intermediate plate, the intelligent cockpit daughter board and the intelligent driving daughter board being located between the intermediate plate and the heat dissipation cover plate, and the heat dissipation cover plate being provided with a cooling pipeline.

In a preferred technical solution of the controller, the heat dissipation cover plate is provided with a maintenance opening, the maintenance opening being arranged at a position corresponding to the intelligent cockpit daughter board or the intelligent driving daughter board.

In a preferred technical solution of the controller, a detachable seal cover is arranged on the maintenance opening.

In a preferred technical solution of the controller, the controller further comprises a bottom cover, the bottom cover being arranged on the intermediate plate, and the mother board being located between the intermediate plate and the bottom cover.

In a preferred technical solution of the controller, the heat dissipation cover plate is provided with a boss, the boss being capable of passing through the intermediate plate and being connected to the bottom cover by means of a heat-conducting adhesive.

In a preferred technical solution of the controller, a heat dissipation pipe is embedded in the bottom cover.

In a preferred technical solution of the controller, the controller further comprises a first connector and a second connector, sockets and pins of the first connector being arranged on the intelligent cockpit daughter board and the mother board respectively, sockets and pins of the second connector being arranged on the intelligent driving daughter board and the mother board respectively, and the intermediate plate being provided with through-holes allowing the first connector and the second connector to pass through.

In a preferred technical solution of the controller, the second connector comprises a signal connector and a power connector, the power connector being arranged at a position close to an edge of the intelligent driving daughter board, and the signal connector being arranged at a position close to the middle of the intelligent driving daughter board.

The disclosure further provides a vehicle comprising a controller of any one of the foregoing technical solutions.

Those skilled in the art can understand that a controller of the disclosure comprises an intelligent cockpit daughter board, an intelligent driving daughter board, a mother board and an intermediate plate, the intelligent cockpit daughter board and the intelligent driving daughter board being provided with an intelligent cockpit chip and an intelligent driving chip respectively, the intelligent cockpit daughter board and the intelligent driving daughter board being arranged on one side of the intermediate plate, and the mother board being arranged on the other side of the intermediate plate.

When the above technical solution is used, according to the controller of the disclosure, an intelligent cockpit core chip and an intelligent driving core chip are respectively arranged on two daughter boards, and the two daughter boards share one mother board, which is more convenient for maintenance and upgrading. In addition, the mother board and daughter boards are arranged on the front and back of the same structural member, such that only a distance tolerance between the front and back of this structural member needs to be controlled for a Z-direction fitting height, facilitating installation.

### BRIEF DESCRIPTION OF DRAWINGS

Preferred implementations of the disclosure are described below with reference to the accompanying drawings, in which:
FIG. 1 is an assembly exploded view of a controller of the disclosure;
FIG. 2 is a front structural diagram of an intelligent cockpit daughter board and an intelligent driving daughter board of the disclosure;
FIG. 3 is a back structural diagram of an intelligent cockpit daughter board and an intelligent driving daughter board of the disclosure;
FIG. 4 is a structural diagram of a mother board of the disclosure; and
FIG. 5 is a structural diagram of a controller of the disclosure.

### List of reference signs:

1. intelligent cockpit daughter board; 2. intelligent driving daughter board; 3. mother board; 4. intermediate plate; 41. via hole; 5. heat dissipation cover plate; 51. maintenance opening; 52. seal cover; 53. boss; 54. cooling pipeline; 6. bottom cover; 71. first connector; 72. second connector; 73. third connector; 8. intelligent cockpit chip; 9. intelligent driving chip; 10. heat dissipation pipe.

### DESCRIPTION OF EMBODIMENTS

Preferred implementations of the disclosure are described below with reference to the accompanying drawings. Those skilled in the art should understand that these implementations are only used to explain the technical principles of the disclosure, and are not intended to limit the scope of protection of the disclosure. Those skilled in the art can make adjustments to the implementations according to requirements, so as to adapt to specific application scenarios. For example, although the disclosure is described based on an electric vehicle, this is not restrictive. The controller in the disclosure may also be applied to fuel vehicles and other vehicles.

It should be noted that, in the description of the disclosure, the term that indicates the direction or positional relationship, such as "upper", is based on the direction or positional relationship shown in the accompanying drawings, which is merely for ease of description instead of indicating or implying that the device or element must have a particular orientation and be constructed and operated in a particular orientation, and therefore, should not be construed as limiting the disclosure. In addition, the terms "first" and "second" are used for descriptive purposes only, and cannot be construed as indicating or implying relative importance.

In addition, it should also be noted that, in the description of the disclosure, the term "connect" should be interpreted in a broad sense unless explicitly defined and limited otherwise. For example, the terms may mean a fixed connection, a detachable connection or an integral connection; may mean a mechanical connection; or may be a direct connection, an indirect connection by means of an intermediary, or internal communication between two elements. For those skilled in the art, the specific meanings of the foregoing terms in the disclosure can be interpreted according to a specific situation.

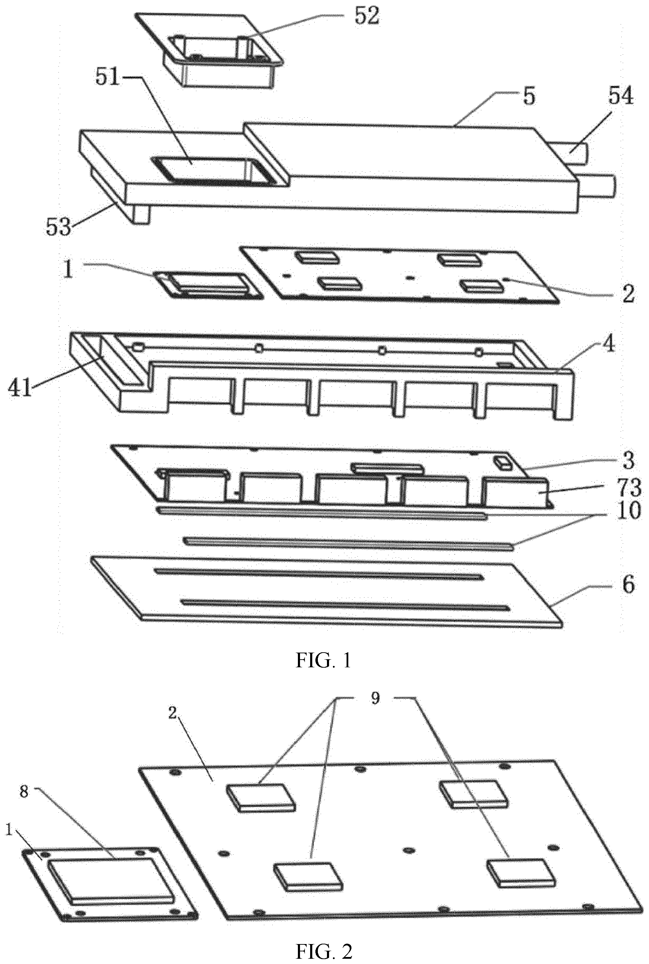

As shown in FIGS. 1 and 2, in order to solve the problems of high cost and inconvenient maintenance and upgrading of the existing intelligent driving hardware and intelligent cockpit hardware, a controller of the disclosure comprises an intelligent cockpit daughter board 1, an intelligent driving daughter board 2, a mother board 3 and an intermediate plate 4, the intelligent cockpit daughter board 1 and the intelligent driving daughter board 2 being provided with an intelligent cockpit chip 8 and an intelligent driving chip 9 respectively, the intelligent cockpit daughter board 1 and the intelligent driving daughter board 2 being arranged on one side of the intermediate plate 4, and the mother board 3 being arranged on the other side of the intermediate plate 4.

The above configuration has the following advantages: an intelligent cockpit core chip and an intelligent driving core chip are respectively arranged on two daughter boards, and the two daughter boards share one mother board, which is more convenient for maintenance and upgrading. In addition, the mother board and the daughter boards are locked and attached to the front and back of the same structural member, such that only a distance tolerance between the front and back of this structural member needs to be controlled for a Z-direction fitting height, facilitating the plug-in fitting of a board-to-board connector.

As shown in FIGS. 1 and 2, in a possible implementation, a controller comprises an intelligent cockpit daughter board 1, an intelligent driving daughter board 2, a mother board 3, an intermediate plate 4, a heat dissipation cover plate 5 and a bottom cover 6, the intelligent cockpit daughter board 1 and the intelligent driving daughter board 2 being provided with an intelligent cockpit chip 8 and an intelligent driving chip 9 respectively, the intelligent cockpit daughter board 1 and the intelligent driving daughter board 2 being arranged on one side of the intermediate plate 4, and the mother board 3 being arranged on the other side of the intermediate plate 4, wherein the intelligent cockpit daughter board 1 and the intelligent driving daughter board 2 may be respectively connected to the mother board 3 by bolts or snap-fit connections, that is, the intelligent cockpit daughter board 1 and the intelligent driving daughter board 2 are mechanically connected to the mother board 3. In addition, the intelligent cockpit daughter board 1 and the intelligent driving daughter board 2 are also respectively electrically connected to the mother board 3. In an embodiment, the intelligent cockpit daughter board 1 and the intelligent driving daughter board 2 are connected to the mother board 3 by means of connectors, and through-holes, through which the connectors can pass, are provided in the intermediate plate 4 at positions corresponding to the connectors. The heat dissipation cover plate 5 is arranged on one side of the intermediate plate 4, the bottom cover 6 is arranged on the other side of the intermediate plate 4, the intelligent cockpit daughter board 1 and the intelligent driving daughter board 2 are located between the intermediate plate 4 and the heat dissipation cover plate 5, and the mother board 3 is located between the intermediate plate 4 and the bottom cover 6. Further, the heat dissipation cover plate 5 is provided with a cooling pipeline 54, and a cooling liquid capable of taking away heat from a chip circulates in the cooling pipeline 54. Further, a maintenance opening 51 is arranged at a position of the heat dissipation cover plate 5 corresponding to the intelligent cockpit daughter board 1, and a detachable seal cover 52 is arranged on the maintenance opening 51. The seal cover 52 is fixed on the maintenance opening 51 and is sealed by a sealant in normal cases, and can be removed when maintenance or upgrading of the chip is needed. Alternatively, in another implementation, the maintenance opening 51 may be arranged at a position of the heat dissipation cover plate 5 corresponding to the intelligent driving daughter board 2, and this may be set by those skilled in the art as needed. Finally, the intermediate plate 4, the heat dissipation cover plate 5 and the bottom cover 6 can be fixed by means of, but not limited to, screw locking.

The two daughter boards are arranged on the same side, the heat dissipation cover plate 5 is arranged above the daughter boards, and the cooling pipeline 54 is arranged on the heat dissipation cover plate 5, such that the chips can be directly cooled through the heat dissipation cover plate 5. Because the intelligent cockpit chip is likely to be upgraded more frequently than the intelligent driving chip, the heat dissipation cover plate 5 is provided with a maintenance window corresponding to the intelligent cockpit daughter board 1 to facilitate after-sales maintenance and upgrading.

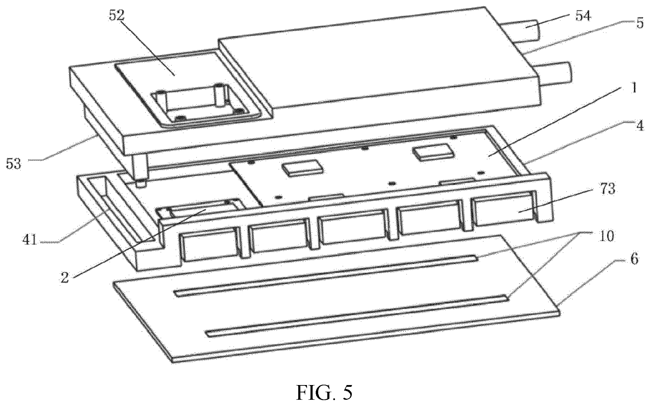

Referring to FIGS. 1 and 5, further, the heat dissipation cover plate 5 is provided with a boss 53, the boss 53 passing through a via hole 41 in the intermediate plate 4 and then being connected to the bottom cover 6 by means of a heat-conducting adhesive to take away the heat from the bottom cover 6, and a heat dissipation pipe 10 is also embedded in the bottom cover 6 to improve the heat dissipation ability for devices located away from the boss of the heat dissipation cover plate.

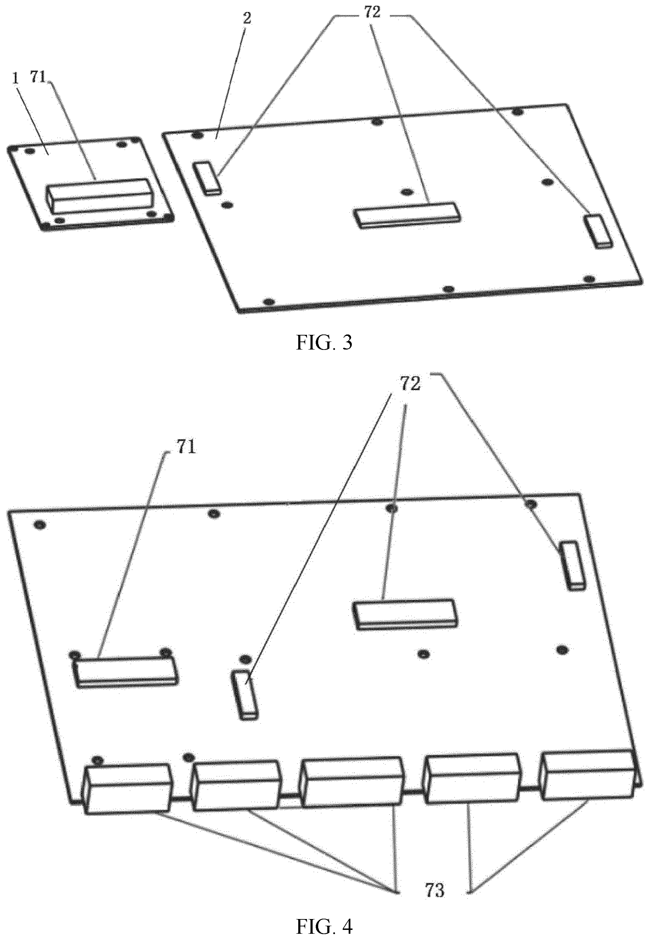

Referring to FIGS. 3 and 4, further, the controller further comprises a first connector 71 and a second connector 72, sockets and pins of the first connector 71 being arranged on the intelligent cockpit daughter board 1 and the mother board 3 respectively, sockets and pins of the second connector 72 being arranged on the intelligent driving daughter board 2 and the mother board 3 respectively, and the first connector 71 and the second connector 72 passing through the through-holes in the intermediate plate 4 to facilitate a plug-in connection of two ends. The intelligent cockpit daughter board 1 and the intelligent driving daughter board 2 are respectively connected to the mother board 3 by means of the first connector 71 and the second connector 72 to transmit current and signals.

Referring to FIG. 3, further, the second connector 72 comprises a signal connector and a power connector. The power connector is arranged at a position close to an edge of the intelligent driving daughter board 2, and the signal connector is arranged at a position close to the middle of the intelligent cockpit daughter board 1. Due to the presence of a plurality of main chips on the intelligent driving daughter board 2 with high power consumption, a plurality of connectors are arranged on the intelligent driving daughter board 2 to transmit signals and power separately. Power is routed along the edge of the board, while the signals traverse the center of the board. This achieves the separation of signals and power, preventing mutual interference. Moreover, the power is transmitted through a plurality of paths, ensuring that power is only completely cut off when a plurality of power connectors fail simultaneously, thereby enhancing safety margins.

Referring to FIGS. 4 and 5, further, the controller further comprises third connectors 73, a plurality of third connectors 73 being arranged at intervals along an edge of the mother board 3, and the intermediate plate 4 is provided with a plurality of grooves capable of accommodating the third connectors 73, such that when the mother board 3 is fixed on the intermediate plate 4, the third connectors 73 just fit into the grooves.

In summary, integrating the intelligent driving hardware and the intelligent cockpit hardware not only achieves deep integration across domains but also reduces the overall hardware cost. Different daughter boards are used to carry chips with different functions, facilitating maintenance and upgrading.

As described in the first paragraph of this section, the above implementations are only used to explain the principles of the disclosure, and are not intended to limit the protection scope of the disclosure. Those skilled in the art can adjust the above structures without departing from the principle of the disclosure, so that the disclosure is applicable to more specific application scenarios.

In addition, the disclosure further provides a vehicle provided with a controller according to any one of the foregoing implementations.

Heretofore, the technical solutions of the disclosure have been described with reference to the preferred implementations shown in the accompanying drawings. However, those skilled in the art can readily understand that the scope of protection of the disclosure is apparently not limited to these specific implementations. Those skilled in the art may make equivalent changes or substitutions to the related technical features without departing from the principle of the disclosure, and all the technical solutions with such changes or substitutions shall fall within the scope of protection of the disclosure.

## Claims

1. A controller, comprising an intelligent cockpit daughter board(1), an intelligent driving daughter board(2), a mother board(3) and an intermediate plate(4), the intelligent cockpit daughter board(1) being provided with an intelligent cockpit chip(8), the intelligent driving daughter board(2) being provided with an intelligent driving chip(9), the intelligent cockpit daughter board(1) and the intelligent driving daughter board(2) being arranged on one side of the intermediate plate(4), and the mother board(3) being arranged on the other side of the intermediate plate(4).

2. The controller according to claim 1, wherein the controller further comprises a heat dissipation cover plate(5), the heat dissipation cover plate(5) being arranged on one side of the intermediate plate(4), the intelligent cockpit daughter board(1) and the intelligent driving daughter board(2) being located between the intermediate plate(4) and the heat dissipation cover plate(5), and the heat dissipation cover plate(5) being provided with a cooling pipeline(54).

3. The controller according to claim 2, wherein the heat dissipation cover plate(5) is provided with a maintenance opening(51), the maintenance opening(51) being arranged at a position corresponding to the intelligent cockpit daughter board(1) or the intelligent driving daughter board(2).

4. The controller according to claim 3, wherein a detachable seal cover(52) is arranged on the maintenance opening(51).

5. The controller according to claim 2, wherein the controller further comprises a bottom cover(6), the bottom cover(6) being arranged on the other side of the intermediate plate(4), and the mother board(3) being located between the intermediate plate(4) and the bottom cover(6).

6. The controller according to claim 5, wherein the heat dissipation cover plate(5) is provided with a boss(53), the boss(53) passing through the intermediate plate(4) and being connected to the bottom cover(6) by means of a heat-conducting adhesive.

7. The controller according to claim 5, wherein a heat dissipation pipe(10) is embedded in the bottom cover(6).

8. The controller according to claim 1, wherein the controller further comprises a first connector(71) and a second connector(72), sockets and pins of the first connector(71) being arranged on the intelligent cockpit daughter board(1) and the mother board(3) respectively, sockets and pins of the second connector(72) being arranged on the intelligent driving daughter board(2) and the mother board(3) respectively, and the intermediate plate(4) being provided with through-holes allowing the first connector(71) and the second connector(72) to pass through.

9. The controller according to claim 8, wherein the second connector(72) comprises a signal connector and a power connector, the power connector being arranged at a position close to an edge of the intelligent driving daughter board(2), and the signal connector being arranged at a position close to the middle of the intelligent driving daughter board(2).

10. A vehicle, comprising a controller of any one of claims 1-9.
